# DEMANDE DE BREVET EUROPEEN

(11) **EP 4 719 027 A1**
(43) Date de publication de la demande: **01.04.2026**
(21) Numéro de dépôt: 25204063.9
(22) Date de dépôt: 23.09.2025
(51) Int. Cl.: H10W 20/00

(54) **PROCÉDÉ DE FABRICATION D'UNE STRUCTURE D'INTERCONNEXION ÉLECTRIQUE HAUTE DENSITÉ**

(30) Priorité: 26.09.2024 FR 2410313
(71) Demandeur: Commissariat à l'Energie Atomique et aux Energies Alternatives, 75015 Paris (FR)
(72) Inventeur: BOREL, Stéphan, 38054 GRENOBLE Cedex 9 (FR); ASSOUS, Myriam, 38054 GRENOBLE Cedex 9 (FR); SOCQUET-CLERC, Carole, 38054 GRENOBLE Cedex 9 (FR); BOUIS, Renan, 38054 GRENOBLE Cedex 9 (FR); CORNELIS, Arnaud, 38054 GRENOBLE Cedex 9 (FR)
(74) Mandataire: Germain Maureau

(57) **Abrégé**

L'invention concerne un procédé de fabrication d'une structure d'interconnexion électrique (1) comprenant une étape de mise à disposition (E0) d'une structure initiale (10) comprenant un substrat (3), un élément inférieur (2) électriquement conducteur, une cavité (20) ménagée dans le substrat (3) et présentant une paroi interne (23) définissant intérieurement un accès à l'élément inférieur (2), et une couche électriquement isolante (30) ; une étape de formation (E1) d'un élément d'interconnexion (40) dans la cavité (20) ; et une étape de polissage finale (E3), dans laquelle une portion de l'élément d'interconnexion (40) et au moins une partie de la couche électriquement isolante (30) sont retirées simultanément par polissage mécanochimique par l'intermédiaire d'un agent de polissage final, formant ainsi la structure d'interconnexion électrique (1).

## Description

### Domaine technique de l'invention

La présente invention concerne un procédé de fabrication d'une structure d'interconnexion électrique, notamment pour établir une connexion électrique entre deux faces d'un substrat.

### Etat de la technique

Dans le domaine de la microélectronique, la réduction des dimensions des composants atteint une limite. Afin de densifier le nombre de composants électroniques dans un système, les recherches s'orientent maintenant vers l'intégration tridimensionnelle. Une telle intégration permet d'empiler des puces dans différentes couches, et de les relier par des vias traversants, connu sous le nom anglais de TSV pour Through Silicon Via.

Les TSV sont des éléments électriques formés au travers de la matière constitutive du substrat, de manière à connecter électriquement deux faces opposées du substrat. Ainsi, des contacts électriques peuvent être repris sur une face du substrat qui est opposée à la face où se situent, par exemple, les dispositifs microélectroniques. Ainsi, un intérêt majeur des TSV est qu'ils permettent d'obtenir une structure plus compacte.

Dans le cas des structures 3D et de manière générale pour les dispositifs complexes, il est avantageux de prévoir une structure comprenant des TSV répartis à haute densité dans le substrat. Les TSV sont d'ailleurs de plus en plus utilisés, par exemple en combinaison avec le collage hybride, pour réaliser des empilements multi-wafers (ou multi-substrats) destinés aux applications imageurs notamment. Dans une structure trois couches 3L « classique », les TSV traversent le wafer du milieu (tier 2) lorsque celui-ci est retourné, et permettent de le connecter électriquement au wafer supérieur (tier 3). Les procédés de fabrication cherchent donc à maximiser le nombre de TSV débouchant sur une face du substrat par unité de surface.

Bien que les résultats actuels permettent d'obtenir une quantité de TSV par unité de surface très importante, cette densité est limitée par différents facteurs provenant des procédés utilisés. Tout d'abord, la distance séparant deux TSV proches est contrainte par la précision d'alignement des appareils de lithographie, qui impose une certaine garde entre les TSV et les plots sur lesquels ils se connectent. Pour les applications actuelles, les précisions obtenues avec ces appareils restent cependant très bonnes et ne pénalisent pas trop fortement la réalisation des TSV haute densité.

Une deuxième limitation provient du procédé de gravure dans la formation des TSV. Plus particulièrement, l'approche appelée « via last » en anglais est une approche considérée comme moins coûteuse pour la formation de TSV. Cette approche comprend une étape de gravure (appellée « etch back » en anglais) qui consiste à graver le matériau isolant en fond de cavité pour permettre la reprise de contact avec le dispositif électronique sur la face avant du substrat. Lors de cette étape, il se produit un facettage dans le matériau isolant surplombant le TSV qui élargit le TSV (de l'ordre de la centaine de nanomètres par bord). Le diamètre apparent du TSV est donc augmenté, et les TSV ne peuvent pas se rapprocher les uns des autres au-delà de cet élargissement, sous peine d'être en court-circuit.

Il existe donc un besoin de trouver un procédé de fabrication d'une structure d'interconnexion électrique qui soit peu coûteux, et qui permette d'obtenir une densité de TSV par unité de surface telle qu'un espacement entre deux TSV est inférieur à 300 nm.

### Objet de l'invention

La présente invention a pour but de proposer une solution qui réponde à tout ou partie des problèmes précités.

Ce but peut être atteint grâce à la mise en oeuvre d'un procédé de fabrication d'une structure d'interconnexion électrique comprenant :
- une étape de mise à disposition d'une structure initiale, ladite structure initiale comprenant :
   ∘ un substrat présentant une face supérieure et une face inférieure opposée à la face supérieure ;
   ∘ au moins un élément inférieur électriquement conducteur agencé du côté de la face inférieure du substrat ;
   ∘ au moins une cavité ménagée dans le substrat et comprenant un orifice supérieur débouchant du côté de la face supérieure du substrat, ladite au moins une cavité présentant une paroi interne définissant intérieurement un accès à l'élément inférieur à partir de la face supérieure du substrat ;
   ∘ une couche électriquement isolante comprenant une portion supérieure agencée sur la face supérieure du substrat et une portion verticale agencée sur la paroi interne de ladite au moins une cavité, la couche électriquement isolante comprenant un chanfrein agencé entre la portion supérieure et la portion verticale ;
- une étape de formation d'un élément d'interconnexion, dans laquelle un matériau électriquement conducteur est déposé du côté de la face supérieure du substrat de manière à former ledit élément d'interconnexion dans la cavité, l'élément d'interconnexion étant en connexion électrique avec l'élément inférieur d'une part et débouchant par l'orifice supérieur du côté de la face supérieure du substrat d'autre part ledit élément d'interconnexion comprenant une partie traversante dans la cavité, et une couche excédentaire du même matériau conducteur que celui de la partie traversante et recouvrant la portion supérieure de la couche électriquement isolante ;
- une étape de polissage primaire, dans laquelle la couche excédentaire de l'élément d'interconnexion est retirée par polissage mécanochimique par l'intermédiaire d'un agent de polissage primaire ; puis
- une étape de polissage finale, dans laquelle une portion de l'élément d'interconnexion et au moins une partie de la portion supérieure de la couche électriquement isolante sont retirés simultanément par polissage mécanochimique par l'intermédiaire d'un agent de polissage final, formant ainsi la structure d'interconnexion électrique, l'étape de polissage finale étant mise en oeuvre jusqu'à ce qu'une épaisseur de la couche électriquement isolante retirée par polissage mécanochimique soit supérieure ou égale à une hauteur du chanfrein.

Les dispositions précédemment décrites permettent de proposer un procédé de fabrication permettant de former une structure d'interconnexion électrique avec une grande densité de TSV traversant le silicium.

Le procédé de fabrication peut en outre présenter une ou plusieurs des caractéristiques suivantes, prises seules ou en combinaison. Selon un mode de réalisation, le substrat est un substrat en silicium

Selon un mode de réalisation, la partie traversante de l'élément d'interconnexion est un TSV, de l'anglais Through Silicon Via.

De manière générale, la face supérieure du substrat est vue selon un plan généralement disposé horizontalement. Ainsi, par « portion verticale », on entend une portion s'étendant selon une direction transversale à la face supérieure du substrat. Cette direction peut par exemple être sensiblement perpendiculaire à un plan d'extension de la face supérieure du substrat.

Selon un mode de réalisation, l'étape de formation de l'élément d'interconnexion comprend :
- la formation d'une partie traversante dans la cavité ; et
- la formation d'une couche excédentaire du même matériau conducteur que celui de la partie traversante et recouvrant la portion supérieure de la couche électriquement isolante.

Ainsi, il est possible de s'assurer que l'élément d'interconnexion traverse l'intégralité des couches formant la structure initiale, et débouche de la cavité au-delà de la couche électriquement isolante.

Selon un mode de réalisation, l'agent de polissage primaire est différent de l'agent de polissage final.

Selon un mode de réalisation, l'étape de polissage finale est mise en œuvre jusqu'à ce que l'épaisseur de la couche électriquement isolante retirée par polissage mécanochimique soit égale à la hauteur du chanfrein. En d'autres termes, l'étape de polissage finale est mise en oeuvre jusqu'au retrait du chanfrein.

De cette manière, il est possible d'obtenir un élément d'interconnexion dans lequel les parties traversantes 41 ne présentent pas d'augmentation de diamètre au niveau de l'orifice supérieur. Par ailleurs, il est possible de garantir la présence d'une épaisseur de couche électriquement isolante suffisamment importante pour assurer une isolation électrique de part et d'autre de la portion supérieure de la couche électriquement isolante.

De manière générale, la hauteur du chanfrein est mesurée transversalement à la face supérieure du substrat, et notamment perpendiculairement à la face supérieure du substrat.

Selon un mode de réalisation, l'étape de formation de l'élément d'interconnexion comprend en outre la formation d'une couche barrière, disposée entre l'élément d'interconnexion et la couche électriquement isolante.

Selon un mode de réalisation, l'étape de polissage finale comprend les deux sous-étapes successives suivantes :
- une première sous étape de polissage finale dans laquelle une portion de l'élément d'interconnexion et une portion de la couche barrière sont retirées simultanément par polissage mécanochimique par l'intermédiaire de l'agent de polissage final ; puis
- une deuxième sous étape de polissage finale dans laquelle une portion de l'élément d'interconnexion, une portion de la couche barrière, et au moins une partie de la portion supérieure de la couche électriquement isolante sont retirées simultanément par polissage mécanochimique par l'intermédiaire de l'agent de polissage final.

Selon un mode de réalisation, lors de l'étape de polissage primaire, l'agent de polissage primaire comprend :
- 88% à 98% en masse d'eau désionisée ;
- 1% à 5% en masse de silice ;
- 1% à strictement moins que 5% en masse de 1,2,4-Triazole ;
- 0,1% à 1% en masse d'éthylène glycol.

Selon un mode de réalisation, le procédé de fabrication comprend en outre une étape de réalisation de plots d'interconnexion mise en œuvre après l'étape de polissage finale, dans laquelle au moins un plot d'interconnexion est réalisé à l'aplomb de l'élément d'interconnexion, du côté de la face supérieure.

Ainsi, il est possible de reprendre des contacts électriques au niveau des éléments d'interconnexion débouchant du substrat.

En d'autres termes, un plot d'interconnexion peut être formé au droit de chaque partie traversante 43 de l'élément d'interconnexion.

Selon un mode de réalisation, lors de l'étape de formation de l'élément d'interconnexion, le matériau déposé comprend du cuivre, du tungstène, du niobium, du tantale, du nickel, de l'aluminium, ou tout autre matériau adapté pour réaliser un élément d'interconnexion traversant.

De cette manière, il est possible d'obtenir un élément d'interconnexion ayant des bonnes propriétés de conduction électrique.

Selon un mode de réalisation, la couche électriquement isolante comprend un oxyde de silicium.

Ce type de matériau isolant est simple à déposer et présente un coût faible.

Selon un mode de réalisation, lors de l'étape de mise à disposition de la structure initiale, la structure initiale comprend une pluralité de cavités ménagées dans le substrat, l'étape de formation de l'élément d'interconnexion comprenant alors la formation d'une pluralité de parties traversantes dans lesdites cavités.

De cette manière, à l'issue de l'étape de polissage finale, il est possible de former une structure comprenant une pluralité de TSV, où chaque TSV correspond à une des parties traversantes de l'élément d'interconnexion.

Selon un mode de réalisation, le retrait de la couche excédentaire lors de l'étape de polissage primaire permet de former une pluralité de TSV, où chaque TSV correspond à une des parties traversantes, chaque TSV étant en connexion électrique avec un des éléments inférieurs d'une part et étant débouchant du côté de la face supérieure du substrat d'autre part.

Ainsi, le procédé de fabrication est adapté pour la formation d'une structure d'interconnexion électrique à base de TSV à haute densité, où le dépôt du matériau formant des TSV dans les cavités est réalisé collectivement dans toutes les cavités.

Selon un mode de réalisation, lors de l'étape de mise à disposition de la structure initiale, chaque cavité est séparée d'au moins une autre des cavités d'une distance qui est strictement inférieure à 10 µm, de préférence strictement inférieure à 5 µm, et de préférence strictement inférieure à 1 µm.

Le procédé de fabrication est donc adapté pour la fabrication d'une structure d'interconnexion électrique à haute densité.

Selon un mode de réalisation, lors de l'étape de polissage finale, l'agent de polissage final comprend :
- 68 à 84 % en masse d'eau désionisée ;
- 15 à 30 % en masse de silice ;
- 1 à 2 % en masse de matière organique.

De manière avantageuse, il a été constaté que l'utilisation d'un tel agent de polissage final permettait de rendre moins sélectif le retrait de matière lors de l'étape de polissage final.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique détaillée d'une succession d'étapes conduisant à la mise à disposition de la structure initiale selon un mode de réalisation particulier de l'invention.
La figure 2 est une vue schématique de l'étape de mise à disposition de la structure initiale et de l'étape de formation de l'élément d'interconnexion selon un mode de réalisation particulier de l'invention.
La figure 3 est une vue schématique de l'étape de polissage primaire et de l'étape de polissage finale selon un mode de réalisation particulier de l'invention.
La figure 4 est une vue schématique de l'étape de réalisation de plots d'interconnexion selon un mode de réalisation particulier de l'invention.
La figure 5 est une vue schématique présentant le sommet d'une structure d'interconnexion fabriquée selon l'état de la technique (A) et le sommet d'une structure d'interconnexion obtenue selon un mode de réalisation particulier de l'invention (B).
La figure 6 est une vue schématique de l'étape de polissage primaire et de l'étape de polissage finale selon un mode de réalisation particulier de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

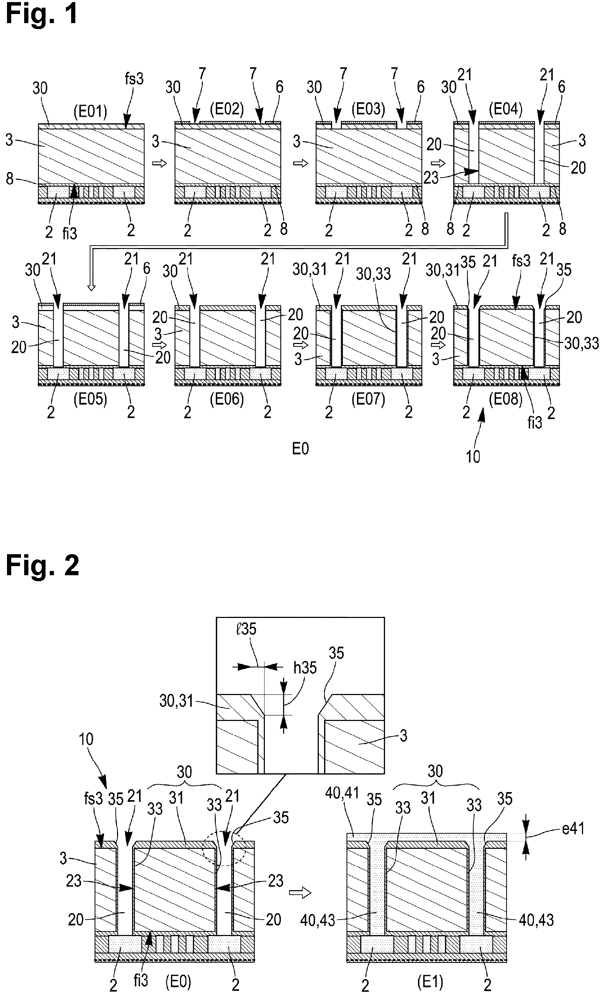

Comme on peut le voir sur les figures 1 à 4, l'invention concerne un procédé de fabrication d'une structure d'interconnexion électrique 1.

Le procédé de fabrication comprend tout d'abord une étape de mise à disposition E0 d'une structure initiale 10. La figure 1 illustre un mode de réalisation non limitatif présentant la succession d'étapes technologiques permettant d'aboutir à la mise à disposition E0 de la structure initiale 10.

Ce mode de réalisation prévoit tout d'abord la fourniture E01 d'un empilement initial comprenant un substrat 3 présentant une face supérieure fs3 et une face inférieure fi3 opposée à la face supérieure fs3. Par exemple, ce substrat 3 peut être un substrat en silicium.

De manière générale, la face supérieure fs3 du substrat 3 est vue selon un plan disposé horizontalement. Ainsi, pour faciliter la compréhension et la description des figures, il sera utilisé dans la suite de la description les termes « horizontal » ou « vertical », faisant référence à l'orientation des éléments décrits par rapport au plan d'élongation du substrat 3. Toutefois ces termes ne sont pas limitatifs quant à l'orientation des éléments dans l'espace. De la même manière, les termes « au-dessus » ou « en dessous » sont utilisés dans la suite de la description pour situer les éléments selon le sens dans lequel ils sont présentés sur les figures. Ces termes ne présagent cependant en rien de leur disposition relative par rapport à la gravité dans l'utilisation finale du dispositif électronique.

L'empilement initial comprend également au moins un élément inférieur 2 électriquement conducteur agencé du côté de la face inférieure fi3 du substrat 3, c'est à dire en dessous du substrat selon le mode de réalisation représenté. Sur la figure 1 notamment, l'empilement initial représente deux éléments inférieurs 2. Il est cependant bien compris que dans le domaine d'application considéré, le nombre d'éléments inférieurs est bien plus important. Bien que cela ne soit pas limitatif, une couche isolante inférieure 8 peut être disposée entre la face inférieure fi3 du substrat 3 et l'élément inférieur 2.

L'empilement initial comprend également une couche électriquement isolante 30 disposée sur la face supérieure fs3 du substrat 3. La couche électriquement isolante, appelée également couche isolante 30 est donc disposée du côté opposé aux éléments inférieurs 2 par rapport au substrat 3. Cette couche isolante 30 peut avantageusement comprendre un oxyde de silicium. Ce type de matériau isolant est simple à déposer et présente un coût faible.

Lors de l'étape E02, une couche de résine 6 peut être déposée sur la couche isolante 30, puis insolée et développée par photolithographie, afin de former des ouvertures 7 dans la couche de résine 6. De manière générale, une telle étape E02 est réalisée de sorte qu'une ouverture 7 soit ménagée au droit de chaque élément inférieur 2 au niveau duquel un accès traversant doit être réalisé.

Plusieurs étapes de gravures peuvent alors être mises en œuvre pour former un accès aux éléments inférieurs 2 depuis la face supérieure fs3 du substrat 3. Tout d'abord, l'étape E03 consiste à prolonger, par gravure, les ouvertures 7 dans la couche isolante 30. L'étape E04 est ensuite mise en œuvre pour graver la matière constitutive du substrat 3, pour prolonger les ouvertures 7 verticalement, et ménager ainsi un canal dans le substrat 3. Une telle étape peut par exemple être mise en œuvre par gravure ionique réactive profonde (ou DRIE de l'anglais « Deep Reactive Ion Etching »). Généralement, les canaux ainsi formés présentent une forme générale cylindrique qui s'étend verticalement à travers le substrat 3 entre la face supérieure fs3 et la face inférieure fi3.

Dans le cas où une couche isolante inférieure 8 est présente, une étape de gravure E05 peut être mise en œuvre pour retirer des portions de cette couche isolante inférieure 8 disposées au-dessus des éléments inférieurs 2. Le résultat des étapes E02 à E04 (voire E05) est de permettre la formation d'au moins une cavité 20 ménagée dans le substrat 3, et notamment une pluralité de cavités 20 ménagées dans le substrat 3. Chacune des cavités comprend alors un orifice supérieur 21 débouchant du côté de la face supérieure fs3 du substrat 3 et une paroi interne 23.

L'étape E06 peut ensuite être mise en œuvre pour retirer la couche de résine 6.

Lors de l'étape E07, un matériau isolant, par exemple un oxyde de silicium, est déposé de sorte que la couche isolante 30 comprenne une portion supérieure 31 agencée sur la face supérieure fs3 du substrat 3 et une portion verticale 33 agencée sur la paroi interne 23 de ladite au moins une cavité 20. Par « portion verticale 33 », on entend une portion s'étendant selon une direction transversale à la face supérieure fs3 du substrat 3. Cette direction peut par exemple être sensiblement perpendiculaire à un plan d'extension de la face supérieure fs3 du substrat 3. De cette manière, il est possible d'isoler électriquement le substrat 3 de tout élément conducteur formé dans la cavité 20.

A l'issue de l'étape E07, des portions de couche isolante 30 sont disposées au fond de chaque cavité 20 et isolent électriquement les élément inférieurs 2 de l'espace formé à l'intérieur de la cavité 20. Une étape de gravure de fond E08 (ou « etch back » selon la terminologie anglo-saxonne consacrée) doit donc être réalisée pour graver lesdites portions en fond de cavité 20 et permettre ainsi l'accès aux éléments inférieurs 2. Lors de cette étape de gravure de fond E08 se forme généralement un chanfrein 35, ou facette dans la couche isolante 30. Ainsi, pour chaque cavité 20, un chanfrein 35 est agencé entre la portion supérieure 31 et la portion verticale 33 de la couche isolante 30.

Comme on peut le voir sur la figure 2, chaque chanfrein 35 peut être caractérisé par une hauteur h35 de chanfrein 35 mesurée transversalement à la face supérieure fs3 du substrat 3, et notamment perpendiculairement à la face supérieure fs3 du substrat 3 ; et par une largeur l35 de chanfrein 35 comptée perpendiculairement à ladite hauteur de chanfrein h35. Afin de mieux visualiser ces dimensions l35 et h35, la figure 2 présente un agrandissement d'une zone présentant des chanfreins 35.

Comme nous le verrons plus loin, afin de densifier les connexions électriques entre la face supérieure fs3 et la face inférieure fi3 du substrat 3, il peut être prévu que chaque cavité 20 soit séparée d'au moins une autre des cavités 20 d'une distance qui est strictement inférieure à 10 µm, de préférence strictement inférieure à 5 µm, et de préférence strictement inférieure à 1 µm. Une telle distance peut donc être prévue à l'étape E02. Le procédé de fabrication peut donc être adapté pour la fabrication d'une structure d'interconnexion électrique 1 à haute densité.

L'ensemble des étapes E01 à E08 présente un mode de réalisation particulier de mise en oeuvre de l'étape de mise à disposition de la structure initiale 10. Ces étapes E01 à E08 conduisent donc à la formation de la structure initiale 10 comprenant :
- le substrat 3;
- les éléments inférieurs 2 agencés du côté de la face inférieure fi3 du substrat 3 ;
- les cavités 20 ménagées dans le substrat 3, comprenant chacune un orifice supérieur 21 débouchant du côté de la face supérieure fs3 du substrat 3, et présentant une paroi interne 23 définissant intérieurement un accès à un des éléments inférieurs 2 à partir de la face supérieure fs3 du substrat 3 ; et
- la couche électriquement isolante 30 comprenant une portion supérieure 31 agencée sur la face supérieure fs3 du substrat 3 et pour chaque cavité 20, une portion verticale 33 agencée sur la paroi interne 23 de ladite cavité 20, ainsi qu'un chanfrein 35 agencé entre la portion supérieure 31 et la portion verticale 33 de la couche isolante 30.

En référence maintenant à la figure 2, le procédé de fabrication peut comprendre une succession d'étapes conduisant à la formation E1 d'un élément d'interconnexion 40, dans laquelle un matériau électriquement conducteur est déposé du côté de la face supérieure fs3 du substrat 3 de manière à former ledit élément d'interconnexion 40 dans les cavités 20. Par exemple, cette étape de formation E1 d'un élément d'interconnexion 40 peut être mise en œuvre par dépôt électrochimique (ou ECD de l'anglais « ElectroChemical Deposition »), généralement précédé par le dépôt conforme d'une couche barrière (par exemple en nitrure de titane et titane (TiN/Ti)) et d'une couche de germination en un matériau correspondant à celui qui doit être déposé par dépôt électrochimique, par exemple le cuivre. Le matériau déposé peut notamment comprendre au moins un élément chimique choisi dans le groupe composé du cuivre, du tungstène, du niobium, du tantale, du nickel, ou de l'aluminium. De cette manière, il est possible d'obtenir un élément d'interconnexion 40 ayant de bonnes propriétés de conduction électrique.

L'étape de formation E1 de l'élément d'interconnexion 40 peut notamment comprendre la formation d'une partie traversante 43 dans chacune des cavités 20 ; et la formation d'une couche excédentaire 41 du même matériau conducteur que celui de la partie traversante 43 et recouvrant la portion supérieure 31 de la couche électriquement isolante 30. Il est donc bien compris que lors de l'étape de formation E1 de l'élément d'interconnexion 40, il est possible de former une pluralité de parties traversantes 43, connectées entre elles par la couche excédentaire 41. Ainsi, il est possible de s'assurer que l'élément d'interconnexion 40, et notamment que chaque partie traversante 43 traverse l'intégralité des couches formant la structure initiale 10, et débouche des cavités 20 correspondantes au-delà de la couche électriquement isolante 30. Ainsi, l'étape de formation E1 de l'élément d'interconnexion 40 peut comprendre la formation d'une pluralité de parties traversantes 43.

Il en résulte que l'élément d'interconnexion 40 est en connexion électrique avec l'élément inférieur 2 d'une part et débouche par l'orifice supérieur 21 du côté de la face supérieure fs3 du substrat 3 d'autre part. Il est donc bien compris que les parties traversantes 43 de l'élément d'interconnexion assureront à terme, une connexion électrique à travers l'épaisseur du substrat 3. En d'autres termes, les parties traversantes de l'élément d'interconnexion 40 sont destinées à former des TSV, de l'anglais Through Silicon Via, à l'issue du procédé de fabrication.

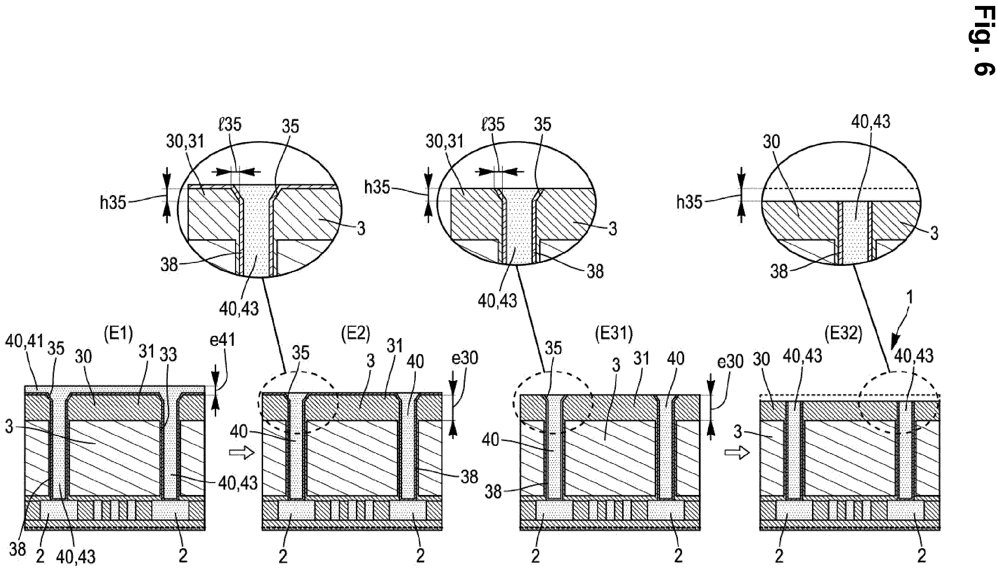

Selon une alternative, représentée sur la figure 6, lors de l'étape de formation E1 de l'élément d'interconnexion 40, une couche barrière 38 peut être déposée, et disposée entre l'élément d'interconnexion 40 et la couche isolante 30. Cette couche barrière 38 peut notamment être en titane/nitrure de titane Ti/TiN.

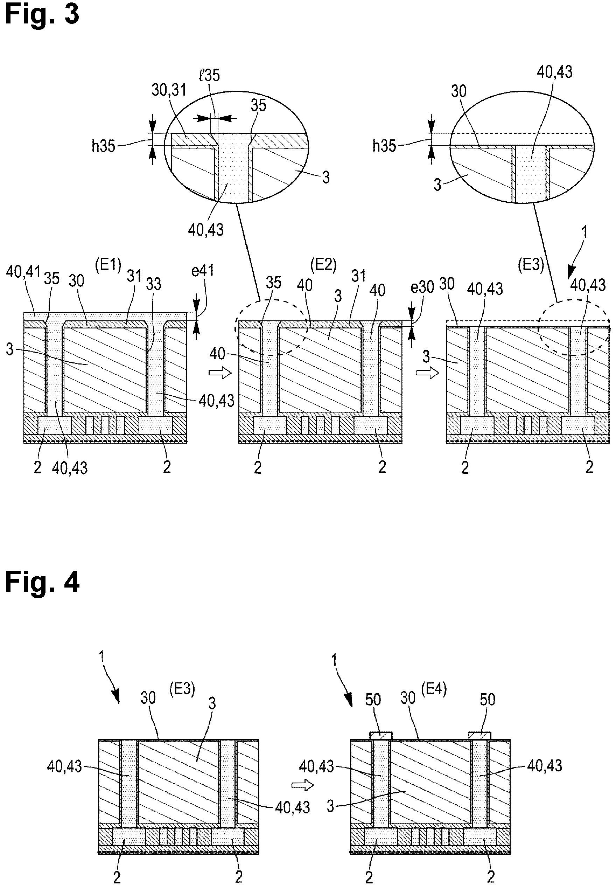

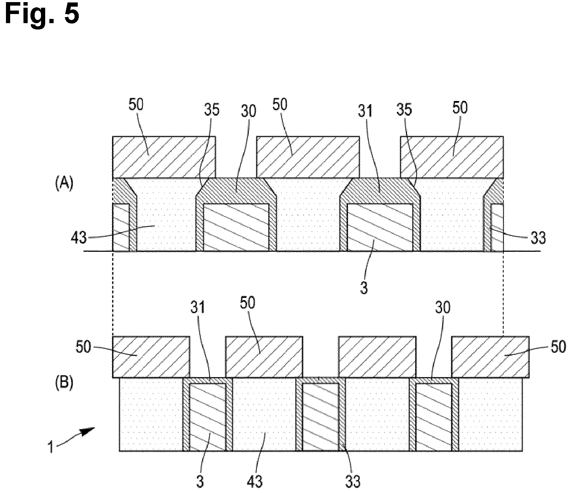

Comme cela est illustré aux figures 3 et 5, le procédé de fabrication comprend en outre une étape de polissage primaire E2, mise en œuvre après l'étape de formation E1 de l'élément d'interconnexion 40, dans laquelle la couche excédentaire 41 de l'élément d'interconnexion 40 est retirée par polissage mécanochimique par l'intermédiaire d'un agent de polissage primaire. De cette manière, il est possible de réaliser un polissage primaire permettant de retirer une épaisseur e41 de matériau de l'élément d'interconnexion 40 correspondant à l'épaisseur de la couche excédentaire 41.

Par exemple, si le matériau de l'élément d'interconnexion 40 comprend du cuivre, l'étape de polissage primaire E2 comprend le retrait du cuivre uniquement. Il est par exemple possible d'arrêter l'étape de polissage primaire E2, par détection magnétique, lorsque la couche excédentaire 41 est retirée totalement. Lorsque la structure comprend une couche barrière 38, il est possible de stopper l'étape de polissage primaire E2 au niveau de la couche barrière 38.

Selon un mode de réalisation, l'agent de polissage primaire peut comprendre :
- 88% à 98% en masse d'eau désionisée ;
- 1% à 5% en masse de silice ;
- 1% à strictement moins que 5% en masse de 1,2,4-Triazole ;
- 0,1% à 1% en masse d'éthylène glycol.

Le retrait de la couche excédentaire 41 lors de l'étape de polissage primaire E2 permet de former une pluralité de TSV, où chaque TSV correspond à une des parties traversantes 43. Chaque TSV étant en connexion électrique avec un des éléments inférieurs 2 d'une part et étant débouchant du côté de la face supérieure fs3 du substrat 3 d'autre part. Ainsi, le procédé de fabrication est adapté pour la formation d'une structure d'interconnexion électrique 1 à plusieurs TSV, où le dépôt du matériau formant les TSV est réalisé collectivement dans toutes les cavités 20.

La figure 3 illustre également la mise en œuvre d'une étape de polissage finale E3, dans laquelle une portion de l'élément d'interconnexion 40 et au moins une partie de la portion supérieure 31 de la couche électriquement isolante 30 sont retirées simultanément par polissage mécanochimique par l'intermédiaire d'un agent de polissage final, formant ainsi la structure d'interconnexion électrique 1. Par exemple, l'agent de polissage final peut comprendre :
- 68 à 84 % en masse d'eau désionisée ;
- 15 à 30 % en masse de silice ;
- 1 à 2 % en masse de matière organique.

De manière avantageuse, il a été constaté que l'utilisation d'un tel agent de polissage final permettait de rendre moins sélectif le retrait de matière lors de l'étape de polissage final E3.

De manière générale, l'agent de polissage primaire est différent de l'agent de polissage final. Ainsi, l'étape de polissage primaire E2 est mise en œuvre avant de réaliser l'étape de polissage finale E3 qui est spécifique au retrait de deux (ou trois) matériaux simultanés. Il est ainsi possible d'adapter le type d'agent de polissage au type de polissage mécanochimique réalisé. Toutefois, il est possible que l'agent de polissage final soit le même que l'agent de polissage primaire. Dans ce cas, l'étape de polissage finale E3 et l'étape de polissage primaire E2 sont mises en œuvre successivement, mais au cours d'une même opération.

La figure 6 illustre une variante dans laquelle, l'étape de polissage finale E3 peut être mise en œuvre en deux sous-étapes successives :
- une première sous étape de polissage finale E31 dans laquelle une portion de l'élément d'interconnexion 40 et une portion de la couche barrière 38 sont retirées simultanément par polissage mécanochimique par l'intermédiaire de l'agent de polissage final ; puis
- une deuxième sous étape de polissage finale E32 dans laquelle une portion de l'élément d'interconnexion 40, une portion de la couche barrière 38 et au moins une partie de la portion supérieure 31 de la couche électriquement isolante 30 sont retirées simultanément par polissage mécanochimique par l'intermédiaire de l'agent de polissage final.

Par exemple, la première sous étape de polissage finale E31 peut être stoppée au bout d'un temps donné, ou par détection d'une variation de couple mécanique. La deuxième sous étape de polissage finale E32 peut être stoppée au bout d'un temps donné.

L'étape de polissage finale E3 est mise en œuvre jusqu'à ce qu'une épaisseur e30 de la couche électriquement isolante 30 retirée par polissage mécanochimique soit supérieure ou égale à une hauteur h35 du chanfrein 35. Plus particulièrement, l'étape de polissage finale E3 peut être mise en œuvre jusqu'à ce que l'épaisseur e30 de la couche électriquement isolante 30 retirée par polissage mécanochimique soit égale à la hauteur h35 du chanfrein 35. En d'autres termes, l'étape de polissage finale E3 est mise en œuvre jusqu'au retrait du chanfrein 35.

Les dispositions précédemment décrites permettent d'obtenir un élément d'interconnexion 40 dans lequel les parties traversantes 43 ne présentent pas d'augmentation de diamètre au niveau de l'orifice supérieur 21. Par ailleurs, il est possible de garantir la présence d'une épaisseur de couche électriquement isolante 30 restante suffisamment importante pour assurer une isolation électrique de part et d'autre de la portion supérieure 31 de la couche électriquement isolante 30.

A l'issue de l'étape de polissage primaire E2 et/ou de l'étape de polissage finale E3, une structure est formée, comprenant une pluralité de TSV, où chaque TSV correspond aux parties traversantes 43.

Enfin, le procédé de fabrication peut comprendre une succession d'étapes conduisant à la réalisation E4 de plots d'interconnexion 50. La réalisation E4 des plots d'interconnexion est mise en œuvre après l'étape de polissage finale E3 illustrée sur la figure 4. Lors de cette étape, au moins un plot d'interconnexion 50 est réalisé à l'aplomb de l'élément d'interconnexion 40, du côté de la face supérieure fs3. En d'autres termes, un plot d'interconnexion 50 peut être formé au droit de chaque partie traversante 43 de l'élément d'interconnexion 40. Ainsi, il est possible de reprendre des contacts électriques au niveau des parties traversantes 43 débouchant du substrat 3. De manière schématique, la figure 5 illustre une comparaison entre le sommet d'une structure d'interconnexion électrique 1 fabriquée selon l'état de la technique (A) et le sommet d'une structure d'interconnexion électrique 1 obtenue selon un mode de réalisation particulier de l'invention (B).

Les dispositions précédemment décrites permettent de proposer un procédé de fabrication permettant de former une structure d'interconnexion électrique 1 avec une grande densité de TSV traversant le silicium.

## Revendications

1. Procédé de fabrication d'une structure d'interconnexion électrique (1) comprenant :
- une étape de mise à disposition (E0) d'une structure initiale (10), ladite structure initiale (10) comprenant :
• un substrat (3) présentant une face supérieure (fs3) et une face inférieure (fi3) opposée à la face supérieure (fs3) ;
• au moins un élément inférieur (2) électriquement conducteur agencé du côté de la face inférieure (fi3) du substrat (3) ;
• au moins une cavité (20) ménagée dans le substrat (3) et comprenant un orifice supérieur (21) débouchant du côté de la face supérieure (fs3) du substrat (3), ladite au moins une cavité (20) présentant une paroi interne (23) définissant intérieurement un accès à l'élément inférieur (2) à partir de la face supérieure (fs3) du substrat (3) ;
• une couche électriquement isolante (30) comprenant une portion supérieure (31) agencée sur la face supérieure (fs3) du substrat (3) et une portion verticale (33) agencée sur la paroi interne (23) de ladite au moins une cavité (20), la couche électriquement isolante (30) comprenant un chanfrein (35) agencé entre la portion supérieure (31) et la portion verticale (33) ;
- une étape de formation (E1) d'un élément d'interconnexion (40), dans laquelle un matériau électriquement conducteur est déposé du côté de la face supérieure (fs3) du substrat (3) de manière à former ledit élément d'interconnexion (40) dans la cavité (20), l'élément d'interconnexion (40) étant en connexion électrique avec l'élément inférieur (2) d'une part et débouchant par l'orifice supérieur (21) du côté de la face supérieure (fs3) du substrat (3) d'autre part, ledit élément d'interconnexion (40) comprenant une partie traversante (43) dans la cavité (20), et une couche excédentaire (41) du même matériau conducteur que celui de la partie traversante (43) et recouvrant la portion supérieure (31) de la couche électriquement isolante (30) ;
- une étape de polissage primaire (E2), dans laquelle la couche excédentaire (41) de l'élément d'interconnexion (40) est retirée par polissage mécanochimique par l'intermédiaire d'un agent de polissage primaire ; puis
- une étape de polissage finale (E3), dans laquelle une portion de l'élément d'interconnexion (40) et au moins une partie de la portion supérieure (31) de la couche électriquement isolante (30) sont retirées simultanément par polissage mécanochimique par l'intermédiaire d'un agent de polissage final, formant ainsi la structure d'interconnexion électrique (1), l'étape de polissage finale (E3) étant mise en oeuvre jusqu'à ce qu'une épaisseur (e30) de la couche électriquement isolante (30) retirée par polissage mécanochimique soit supérieure ou égale à une hauteur (h35) du chanfrein (35).

2. Procédé de fabrication selon la revendication 1, dans lequel l'étape de formation (E1) de l'élément d'interconnexion (40) comprend en outre la formation d'une couche barrière (38), disposée entre l'élément d'interconnexion (40) et la couche électriquement isolante (30).

3. Procédé de fabrication selon la revendication 2, dans lequel l'étape de polissage finale (E3) comprend les deux sous-étapes successives suivantes:
- une première sous étape de polissage finale (E31) dans laquelle une portion de l'élément d'interconnexion (40) et une portion de la couche barrière (38) sont retirées simultanément par polissage mécanochimique par l'intermédiaire de l'agent de polissage final ; puis
- une deuxième sous étape de polissage finale (E32) dans laquelle une portion de l'élément d'interconnexion (40), une portion de la couche barrière (38), et au moins une partie de la portion supérieure (31) de la couche électriquement isolante (30) sont retirées simultanément par polissage mécanochimique par l'intermédiaire de l'agent de polissage final.

4. Procédé de fabrication selon l'une quelconque des revendications 1 à 3, dans lequel lors de l'étape de polissage primaire (E2), l'agent de polissage primaire comprend :
- 88% à 98% en masse d'eau désionisée ;
- 1% à 5% en masse de silice ;
- 1% à strictement moins que 5% en masse de 1,2,4-Triazole ;
- 0,1% à 1% en masse d'éthylène glycol.

5. Procédé de fabrication selon l'une quelconque des revendications 1 à 4, comprenant en outre une étape de réalisation (E4) de plots d'interconnexion (50) mise en œuvre après l'étape de polissage finale (E3), dans laquelle au moins un plot d'interconnexion (50) est réalisé à l'aplomb de l'élément d'interconnexion (40), du côté de la face supérieure (fs3).

6. Procédé de fabrication selon l'une quelconque des revendications 1 à 5, dans lequel la couche électriquement isolante (30) comprend un oxyde de silicium.

7. Procédé de fabrication selon l'une quelconque des revendications 1 à 6, dans lequel lors de l'étape de mise à disposition (E0) de la structure initiale (10), la structure initiale (10) comprend une pluralité de cavités (20) ménagées dans le substrat (3), l'étape de formation (E1) de l'élément d'interconnexion (40) comprenant alors la formation d'une pluralité de parties traversantes (43) dans lesdites cavités (20).

8. Procédé de fabrication selon la revendication 7, dans lequel le retrait de la couche excédentaire (41) lors de l'étape de polissage primaire (E2) permet de former une pluralité de TSV, où chaque TSV correspond à une des parties traversantes (43), chaque TSV étant en connexion électrique avec un des éléments inférieurs (2) d'une part et étant débouchant du côté de la face supérieure (fs3) du substrat (3) d'autre part.

9. Procédé de fabrication selon l'une quelconque des revendications 1 à 8, dans lequel lors de l'étape de mise à disposition (E0), chaque cavité (20) est séparée d'au moins une autre des cavités (20) d'une distance qui est strictement inférieure à 10 µm, de préférence strictement inférieure à 5 µm, et de préférence strictement inférieure à 1 µm.

10. Procédé de fabrication selon l'une quelconque des revendications 1 à 9, dans lequel lors de l'étape de polissage finale (E3), l'agent de polissage final comprend :
- 68 à 84 % en masse d'eau désionisée ;
- 15 à 30 % en masse de silice ;
- 1 à 2 % en masse de matière organique.
